Europäisches Patentamt

European Patent Office

Office européen des brevets

(11) Numéro de publication: **0 263 750 B1**

# FASCICULE DE BREVET EUROPEEN

(45) Date de publication de fascicule du brevet:
**19.06.91**

(51) Int. Cl.⁵: **G11C 27/02, H03K 17/74**

(21) Numéro de dépôt: **87402195.9**

(22) Date de dépôt: **02.10.87**

(54) Echantillonneur-bloqueur à haute fréquence d'échantillonnage.

(30) Priorité: **03.10.86 FR 8613848**

(43) Date de publication de la demande:
**13.04.88 Bulletin 88/15**

(45) Mention de la délivrance du brevet:
**19.06.91 Bulletin 91/25**

(84) Etats contractants désignés:
**DE GB IT NL**

(56) Documents cités:
**US-A- 3 584 920**
**US-A- 3 721 829**
**US-A- 4 518 921**

(73) Titulaire: **THOMSON COMPOSANTS MI-CROONDES**
**173, bld Haussmann**
**F-75008 Paris(FR)**

Titulaire: **CENTRE NATIONAL DE LA RECHER-CHE SCIENTIFIQUE (CNRS)**
**15, Quai Anatole France**
**F-75700 Paris Cedex 07(FR)**

(72) Inventeur: **Martin, Philippe**
**THOMSON-CSF SCPI 19, avenue de Messine**
**F-75008 Paris(FR)**
Inventeur: **Polonovski, Jean-Pierre**
**CENTRE NATIONAL DE LA RECHERCHE SCIENTIFIQUE**
**15, quai A. France F-75700 Paris Cedex(FR)**

(74) Mandataire: **Taboureau, James et al**
**THOMSON-CSF SCPI**
**F-92045 Paris La Défense Cédex 67(FR)**

**Description**

La présente invention concerne un circuit électronique rapide destiné au traitement de l'information dans une chaine de traitement de signal : plus précisément, elle concerne un échantillonneur-bloqueur, qui est préférentiellement réalisé sous forme de circuit intégré, sur silicium ou matériaux rapides du groupe III tels que GaAs par exemple.

Le domaine concerné par cet échantillonneur-bloqueur est celui qui va depuis les fréquences relativement basses -quelques mégahertz- jusqu'aux environs de 1 GHz : mis au point pour les hautes fréquences, le schéma de cet échantillonneur-bloqueur ne l'empêche pas de fonctionner à des fréquences moindres. Il est du type à pont de diodes.

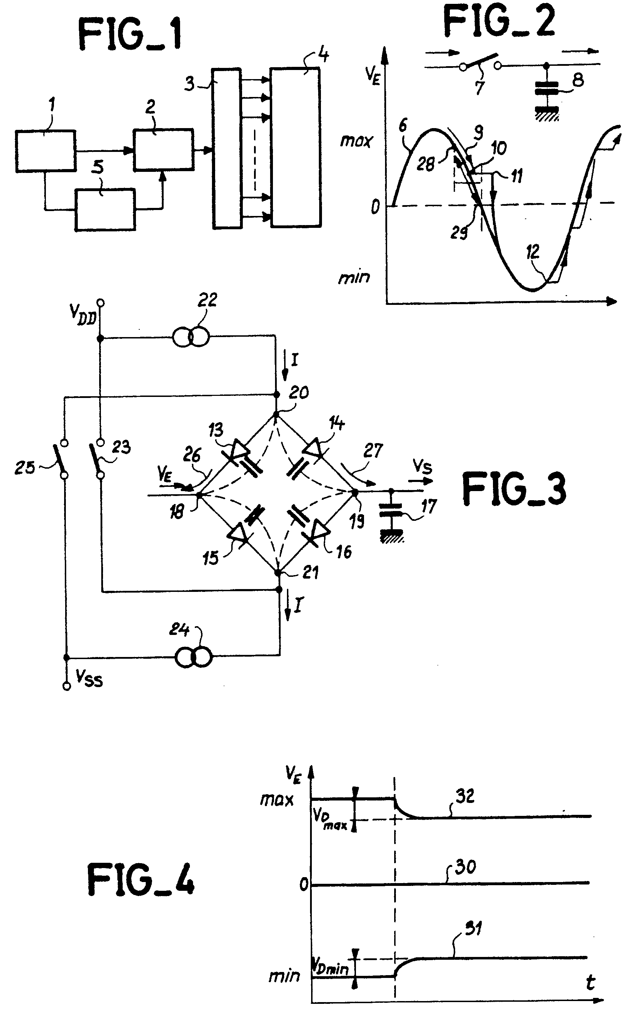

Un échantillonneur-bloqueur intervient dans une chaine de traitement de signal, telle que symbolisée en figure 1. Pour transformer le signal analogique fourni par un capteur 1 en un signal numérisé, deux solutions sont possibles. La première solution consiste à transformer le signal analogique, au moyen d'un convertisseur analogique-numérique (CAN) 2, puis à mémoriser périodiquement les signaux numériques fournis par le CAN : la sortie de la bascule 3 fournit en 4 un signal numérique sur un certain nombre de bits, selon la précision recherchée.

La seconde solution consiste à interposer entre le capteur 1 et le CAN 2 un échantillonneur-bloqueur 5. Celui-ci peut être assimilé à un interrupteur suivi par un condensateur : lorsque l'interrupteur est ouvert, la tension sur sa borne de sortie est mémorisée dans le condensateur, pendant un temps qui ne dépend idéalement que de la fréquence d'horloge qui commande l'ouverture-fermeture de l'interrupteur, mais qui pratiquement dépend de la valeur de la capacité de stockage et de contrainte liées à la technologie utilisée (fuites de courant). La tension du signal analogique, issu du capteur 1, est échantillonnée par l'échantillonneur-bloqueur 5, et numérisée par le convertisseur analogique-numérique 2.

Les échantillonneurs-bloqueurs sont intéressants par leur simplicité, qui favorise l'intégration monolithique, mais par contre les modèles actuels ont des performances en rapidité et en précision inférieures à celles des meilleurs CAN de type "flash". Les limitations proviennent principalement des parasites induits par le signal d'horloge au moment du blocage, et par le signal d'entrée pendant le mode bloqué. Le choix d'une capacité de stockage de valeur élevée pour atténuer ces phénomènes implique une diminution de la fréquence d'échantillonnage, c'est-à-dire une diminution de la largeur de la bande passante. Il y a conflit entre rapidité et précision.

Ces inconvénients ont deux causes. En premier lieu, les échantillonneurs-bloqueurs selon l'art connu sont, comme on le verra plus loin, commandés par deux interrupteurs. Il est difficile de synchroniser les deux interrupteurs d'horloge, soumis à des excursions de potentiel différentes. Ceci demande en pratique deux commandes séparées, imparfaitement synchronisées. En second lieu, une différence des excursions de potentiel aux bornes du pont de diodes, au cours du blocage, amène une injection de la tension d'horloge dans le pont, dépendante de la valeur du signal d'entrée.

Pour remédier à ces inconvénients, l'échantillonneur-bloqueur selon l'invention repose sur deux bases :
- selon un mode préféré, il n'utilise qu'un seul signal d'horloge pour bloquer la tension en sortie du pont,
- il asservit les excursions de tensions aux bornes du pont, par rapport à la tension de sortie, au cours de la période de blocage.

De façon plus précise, l'invention concerne un échantillonneur-bloqueur à haute fréquence d'échantillonnage, comportant un pont de diodes ayant un point d'entrée sur lequel est appliqué un signal analogique d'entrée, un point de sortie sur lequel est recueilli un signal de sortie mémorisé dans une capacité de stockage, et deux points milieux sur lesquels sont forcés les courants de deux sources de courant commandées par deux interrupteurs :
- les deux points milieux étant asservis en tension, en mode bloqué, d'une valeur constante par rapport à la tension de sortie: $V_S$-Kpour le point milieu "haut" et $V_S$ + Kpour le point milieu "bas", cet échantillonneur-bloqueur étant caractérisé en ce que les moyens d'asservissement de la tension des deux points milieux par rapport à la tension de sortie sont constitués par:
- une pluralité, en nombre pair, de diodes montées en diagonale du pont, entre les points milieux "bas" et "haut" et orientées de sorte qu'elles sont polarisées en direct lorsque les diodes du pont sont polarisées en inverse en mode bloqué
- un suiveur de tension qui prélève la tension de sortie au point de sortie du pont, et la recopie au point de symétrie qui partage en deux quantités égales ladite pluralité paire de diodes montées en diagonale du pont.

L'invention sera mieux comprise par la description plus détaillée, qui suit, d'un exemple d'application, s'appuyant sur les figures jointes en annexes, qui représentent:
- figure 1 : chaine de traitement d'un signal analogique, déjà décrite,
- figure 2 : schéma de l'échantillonnage d'un signal, selon l'art connu,

- figure 3 : schéma électrique d'un échantillonneur-bloqueur selon l'art connu,
- figure 4 : graphique des variations du signal échantillonné en fonction du moment d'échantillonnage par rapport à l'amplitude du signal d'entrée,
- figure 5 : schéma électrique d'un échantillonneur-bloqueur selon l'invention,
- figures 6 et 7 : schémas de deux types de suiveurs de tension, en technologie transistors à effet de champ,
- figures 8 et 9 : schéma d'un suiveur de tension, en technologie transistors bipolaires.

La description préalable de l'échantillonnage d'un signal analogique et d'un échantillonneur bloqueur selon l'art connu permettra de mieux comprendre les phénomènes, et les moyens mis en oeuvre dans l'invention pour corriger ces phénomènes.

La figure 2 donne la variation de tension V, dans le temps t, d'un signal analogique représenté par une courbe 6, dont la valeur moyenne est 0 et qui évolue entre un maximum (max) et un minimum (min). Un échantillonneur-bloqueur peut être assimilé à un interrupteur 7, suivi par une capacité 8, et est représenté en étiquette au-dessus de la courbe 6: il est parcouru par le signal à échantillonner. Tant que l'interrupteur 7 est fermé, l'échantillonneur suit, en 9, la variation du signal. A un moment donné, en 10 par exemple, l'interrupteur 7 est ouvert : la tension de sortie de l'interrupteur est stockée dans la capacité 8, donc maintenue constante, et échantillonnée pendant un intervalle de temps, jusqu'en II. A ce moment, l'interrupteur 7 est à nouveau fermé, l'échantillonneur ratrappe puis suit le signal 6 jusqu'au moment où, en 12, le signal est à nouveau échantillonné. Et ainsi de suite. On montre que la fréquence d'échantillonnage doit être supérieure à deux fois la fréquence maxima du signal.

En réalité, un échantillonneur-bloqueur, selon l'art connu, est construit selon le schéma électrique de la figure 3, qu'on trouve par exemple dans le document US-A-3 721 829

L' "interrupteur" est formé par un pont de diodes 13 à 16, et il est suivi par une capacité 17. Le signal d'entrée $V_E$ est appliqué en un premier point I8 du pont de diodes, et le signal de sortie $V_S$ recueilli en un second point 19 du pont, diamétralement opposé au point 18. Sur les troisième et quatrième points 20 et 21 du pont de diodes sont appliquées deux sources de courant. La source 22 force un courant 1 à travers le pont, et peut être coupée par un interrupteur 25. La source 24 tire un courant 1 du pont, et peut être coupée par un interrupteur 23.

Les interrupteurs 23 et 25 sont en fait deux transistors montés en différentiel et alimentés entre $V_{DD}$ et $V_{SS}$ : leurs électrodes de commandes sont commandées par deux signaux en créneaux opposés.

Lorsque les interrupteurs 23 et 25 sont ouverts et que les sources de courant 22 et 24 débitent du point 20 vers le point 21 - bien entendu, les diodes 13 à 16 sont correctement montées pour cela- le courant se partage entre une première voie, diodes 13 et 15, et une seconde voie, diodes 14 et 16: les potentiels sont équilibrés, les tensions aux points 18 et 19 sont les mêmes, la sortie du pont recopie l'entrée et $V_S = V_E$. Le pont suit les variations de la tension d'entrée $V_E$.

Lorsque les interrupteurs 23 et 25 sont fermés, le courant ne passe plus à travers le pont du point 20 vers le point 21. Le signal d'entrée $V_E$ ne peut pas traverser le pont car, quelle que soit sa polarité, il y a toujours deux diodes polarisées en inverse : 13 et 16, ou 14 et 15. Le pont de diodes est équivalent à un interrupteur ouvert, et la tension de sortie $V_S$ est stockée dans la capacité 17, et est mesurée, ou numérisée par un CAN.

Dans la pratique, la tension de sortie $V_S$ ne recopie pas rigoureusement la tension d'entrée $V_E$ pour les raisons déjà évoquées.

D'abord, lorsque le pont est bloqué, chaque diode, vue en inverse, se comporte comme une capacité -représentée en pointillé sur la figure 3- et le pont de diodes est équivalent à une capacité. Les variations de signal d'entrée $V_E$, qui est analogique, se transmettent à travers cette capacité équivalente, et modifient la valeur de $V_S$ car la capacité équivalente et la capacité 17 constituent un diviseur capacitif. En mode bloqué, le signal d'entrée $V_E$ perturbe donc le signal de sortie $V_S$ stocké dans la capacité 17.

Ensuite, on est obligé d'avoir deux sources de courant 22 et 24, l'une qui force un courant à travers le pont, l'autre qui sort ce courant du pont. S'il n'y avait qu'une seule source, 22 par exemple, elle pourrait injecter un courant vers le capteur qui fournit le signal d'entrée $V_E$ selon un chemin symbolisé par la flèche 26, et un courant vers la capacité, selon un chemin symbolisé par la flèche 27, ce qui modifie $V_S$. Il faut donc extraire le courant injecté au moyen de la source 24. Mais s'il y a deux sources de courant 22 et 24, il y a deux interrupteurs 23 et 25, et on sait que la quasi-simultanéïté de fonctionnement de deux interrupteurs n'existe pas.

Ainsi, si l'on se reporte à la figure 2, l'incertitude sur le temps de fermeture des interrupteurs fait que, au lieu d'échantillonner le signal $V_E$ au point 10 par exemple, un premier interrupteur se ferme au point 28 et un second interrupteur se ferme au point 29. Pendant ce temps d'incertitude, le pont de diodes n'est ni ouvert ni bloqué : la difficulté de synchroniser les horloges des deux interrupteurs induit donc des parasites qui perturbent les signaux $V_E$ et $V_S$, et ne respectent pas la symétrie du pont entre ses points d'entrée et de sortie, 18 et 19.

Enfin, avec un échantillonneur-bloqueur selon la figure 3, la valeur de $V_S$ varie avec le moment de l'échantillonnage par rapport au maximum et au minimum du signal $V_E$.

Considérons en figure 4 un signal $V_E$ qui, autour d'une valeur moyenne 0, varie dans le temps t entre un maximum positif max et un minimum négatif min.

Si le pont est bloqué au moment où le signal $V_E$ passe par 0, le point 20 du pont est à une tension $-V_{SS}$, le point 21 est à une tension $V_{DD}$: les excursions de tension s'équilibrent. Lorsque le pont est rendu bloqué, les potentiels des points 20 et 21 n'amènent pas de perturbation si $V_{SS} = V_{DD}$, ce qui est représenté par la droite 30 sur la figure 4.

Si le pont est bloqué lorsque $V_E$ est au minimum ou proche de son minimum, il y a déséquilibre entre le point 21 à $V_{DD}$ et le point 20 à $-V_{SS}$ par rapport au potentiel mémorisé. Lorsque le pont est rendu bloqué, les potentiels des points 20 et 21 modifient le potentiel du point 19, au travers des capacités des diodes ce qui se traduit par la courbe brisée 31.

Si le pont est bloqué lorsque $V_E$ est au maximum ou proche de son maximum, un raisonnement analogue montre que la courbe brisée 32 correspond également à une perturbation dans la mesure de $V_E$.

Il faut donc fixer les potentiels des points 20 et 21, à des tensions symétriques par rapport au potentiel de sortie $V_S$, lorsque le pont est bloqué.

Ces problèmes sont étudiés dans le document US-A-4 518 921, qui montre un schéma dans lequel, à partir du point de sortie de l'échantillonneur-bloqueur, deux branches parallèles, constituées chacune par une diode et une résistance, fixent les potentiels des points milieux par rapport au potentiel de sortie. Mais les diodes et résistances sont des composants passifs, qui ne réagissent pas contre les instabilités amenées par les sources de tensions $V_{DD}$ et $V_{SS}$ ou par les instabilités des composants du circuit, diodes "bruiteuses" par exemple. Annuler ces instabilités suppose un asservissement dynamique.

L'échantillonneur-bloqueur selon l'invention remédie aux inconvénients qui viennent d'être décrits en:

- asservissant les tensions des deux points "milieux" 20 et 21 du pont de diodes, par rapport à la tension du point de sortie 19, pour asservir les excursions de tensions,
- commandant les deux interrupteurs des sources de courant au moyen d'un seul signal d'horloge, pour bloquer la tension en sortie du pont.

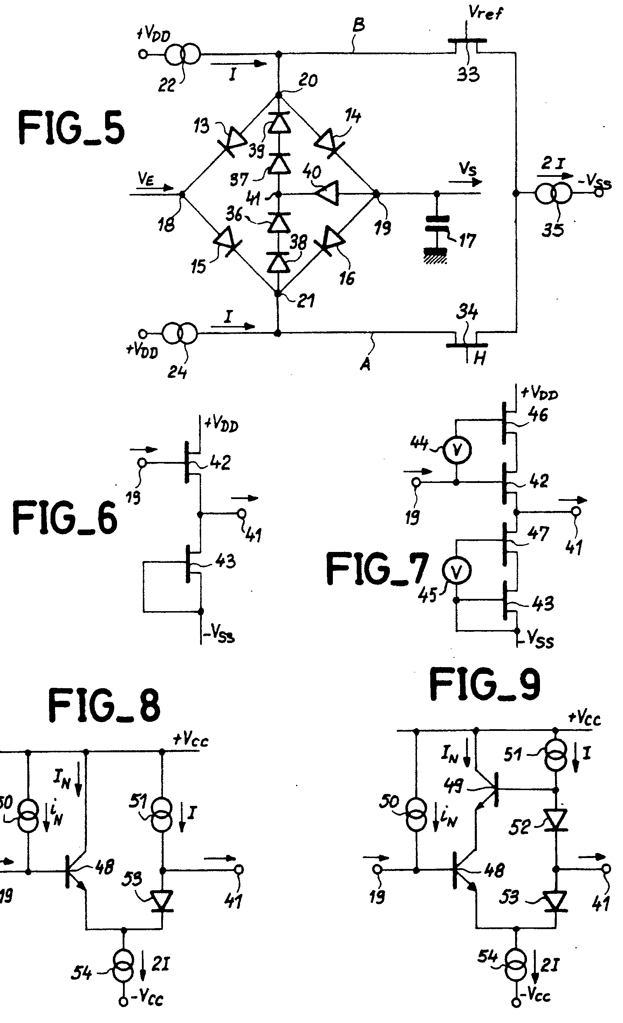

Il est représenté en figure 5. Pour faciliter la comparaison avec l'échantillonneur-bloqueur de la figure 3, les mêmes indices de repères sont conservés lorsqu'ils désignent les mêmes objets.

L'échantillonneur-bloqueur selon l'invention comprend un pont de diodes 13 à 16, comportant un point d'entrée 18 sur lequel est appliqué le signal à traiter $V_E$, un point de sortie 19 sur lequel est recueilli le signal de sortie $V_S$ stocké dans une capacité 17, et deux points "milieux" 20 et 21. Une première source de courant 22 est connectée au point milieu "haut" 20, commun aux diodes 13 et 14 : alimentée par la source de tension $V_{DD}$, cette source 22 débite un courant I. Une deuxième source de courant 24 est connectée au point milieu "bas" 21, commun aux diodes 15 et 16 : alimentée par la source de tension $V_{DD}$, cette source 24 débite un courant I égal au courant de la source 22.

Les interrupteurs des sources de courant 22 et 24 sont constitués par deux transistors 33 et 34 montés en paire différentielle unique. Le premier transistor 33 est monté entre le point commun "haut" 20 et une source de courant 35, réunie à $-V_{SS}$, qui "tire" un courant égal à 2 I. Une tension continue de référence $V_{Ref}$ est appliquée sur l'électrode de commande du transistor 33, grille si c'est un transistor à effet de champ, base si c'est un transistor bipolaire. Le second transistor 34 est monté symétriquement entre le point commun "bas" 21 et la source de courant 35. Une tension d'horloge H en créneaux est appliquée sur son électrode de commande. La tension d'horloge H est tantôt supérieure à la tension de référence $V_{Ref}$, tantôt inférieure, de sorte que le transistor 34 est tantôt plus conducteur que le transistor 33, tantôt moins conducteur.

Dans le pont de diodes lui-même, une pluralité de diodes, en nombre pair, sont montées en diagonale du pont, entre les points "milieux" 21 et 20, de telle façon que ces diodes sont polarisées en direct lorsque les diodes 13 à 16 du pont sont polarisées en inverse. Selon les caractéristiques recherchées, on monte en diagonale deux diodes 36 et 37, ou quatre diodes 36 + 38 et 37 + 39, ou davantage, mais toujours de façon symétrique - donc en nombre pair - par rapport à un point de symétrie 41.

Enfin, un suiveur de tension 40 mesure la tension de sortie $V_S$ au point de sortie 19 du pont de diodes, et la recopie au point de symétrie 41. Ainsi, le potentiel aux deux points milieux "haut" 20 et "bas" 21 est asservi, en mode bloqué, par rapport à la tension de sortie $V_S$ au point 19. La tension au point milieu "haut" 20 est égale à $V_S - K$, et la tension au point milieu "bas" 21 est égale à

$V_S + K$, avec $K = nV_D$, n étant le nombre de diodes en série entre 41 et 20, ou entre 21 et 41, et $V_D$ étant la chute de tension d'une diode 36 à 39.

Cet échantillonneur-bloqueur fonctionne de la façon suivante.

En mode suiveur, la tension d'horloge H, sur l'électrode de commande du transistor 34, est supérieure à la tension continue $V_{ref}$ sur l'électrode de commande du transistor 33 : le transistor 34 est plus conducteur que le transistor 33. Le courant I fourni par la source de courant 22 traverse le pont de diodes 13 à 16, et s'ajoute, dans la branche de circuit repérée "A", au courant I fourni par la source de courant 24. Un courant 2 I passe à travers le transistor 34, et est extrait par la source de courant 35. Le courant I qui traverse le pont assure l'égalité de potentiel entre les points d'entrée 18 et de sortie 19 du pont : $V_S = V_E$. Pendant cette phase, les diodes 36 à 39 montées en diagonale du pont sont polarisées en inverse.

Le pont passe en mode bloqué lorsque la tension d'horloge H devient inférieure à la tension continue $V_{ref}$, et le transistor 34 est bloqué. Il n'y a plus d'incertitude sur le temps d'ouverture des interrupteurs 33 et 34, puisqu'il n y a qu'un seul signal d'horloge H. En mode bloqué, la source de courant 24 débite un courant I dans la pluralité paire de diodes 36 à 39 montées en diagonale du pont. Ce courant I s'ajoute, dans la branche de circuit repérée "B", au courant I fourni par la source de courant 22. Un courant 2 I passe à travers le transistor 33 et est extrait par la source de courant 35.

Le suiveur de tension 40 recopie au point de symétrie 41 la tension de sortie $V_S$ stockée dans la capacité 17 et prélevée au point de sortie 19. Et comme les diodes 36 à 39 montées en diagonale du pont sont identiques et ont même chute de tension $V_D$, la tension, en mode bloqué,au point milieu "haut" 20 est égale à la tension de sortie $V_S$ diminuée d'autant de fois la chute de tension $V_D$ qu'il y a de diodes (37, 39) dans une demi-diagonale. De même, en mode bloqué, la tension au point milieu "bas" 21 est égale à la tension de sortie $V_S$ augmentée d'autant de fois la chute de tension $V_D$ qu'il y a de diodes (36, 38) dans une demi-diagonale. Les tensions des points 20 et 21 sont donc asservies d'une valeur constante par rapport à la tension de sortie $V_S$ recopiée au point de symétrie 41. Dans le cas de la figure 5 -qui ne limite pas la portée de l'invention-puisqu'il y a deux diodes dans chaque demi-diagonale :

$$V_{20} = V_{41} - 2V_D = V_S - 2V_D$$
$$V_{21} = V_{41} + 2V_D = V_S + 2V_D$$

L'asservissement des tensions des points milieux "haut" 20 et "bas" 21 élimine pratiquement totalement l'injection de la tension d'horloge dans le pont.

La gamme dynamique de cet échantillonneur-bloqueur est déterminée par la limite de conduction des diodes en série par rapport au signal d'entrée. Ainsi, entre le point de symétrie 41, sur lequel est appliquée la tension de sortie $V_S$, et le point d'entrée 18 sur lequel est appliquée la tension d'entrée $V_E$, les diodes 37 et 39 d'une demi-diagonale et la diode 13 du pont sont montées dans le sens de conduction. Il y a 3 diodes, et la gamme dynamique est donc

$$\pm \frac{3V_D}{2}.$$

De façon plus générale, si une série de 2n diodes sont montées en diagonale du pont, la gamme dynamique est égale à

$$\pm \frac{(n+1)}{2} V_D.$$

En supposant que le pont ne comporte qu'une seule diode par branche : si le pont comprenait par exemple deux diodes telles que 13 (ou 14, ou 15, ou 16) en série dans chacune de ses branches, la gamme dynamique serait

$$\pm \frac{(n+2)}{2} V_D.$$

Cette dynamique peut être augmentée en agissant sur le nombre de diodes, en nombre pair, montées en diagonale du pont. Les dites diodes peuvent d'ailleurs, de façon plus générale, être remplacées par des sources de tensions polarisées.

On a exposé précédemment, dans le préambule sur les inconvénients des échantillonneurs-bloqueurs, que la symétrie des excursions de tension aux points milieux "haut" et "bas" du pont, par rapport à la tension de sortie stockée dans la capacité, augmente la réjection de la tension d'horloge. Le montage selon l'invention, qui assure une complète symétrie des tensions aux points milieux 20 et 21 par rapport à la tension au point de symétrie 41, c'est-à-dire par rapport à la tension de sortie au point 19, assure donc une très bonne réjection de la tension d'horloge.

Une très bonne réjection du signal d'entrée est également assurée par la faible impédance que présente le suiveur de tension 40 -qui sera détaillé ultérieurement- référençant le point de symétrie 41 par rapport au point de sortie 19. En effet, le courant injecté à travers les capacités du pont de diodes polarisées en inverse, en mode bloqué, ne se traduit que par une faible excursion de tension sur le suiveur 40, et cette excursion de tension se répercute sur les points milieux "haut" et "bas" du pont formant un diviseur capacitif avec la capacité de stockage 17.

Les interrupteurs 33 et 34 qui commandent les sources de courant 22 et 24 sont constitués par une paire différentielle de transistors, qui peuvent être des transistors à effet de champ ou des bipolaires, en silicium ou en arséniure de gallium selon les fréquences considérées. L'important est que les caractéristiques de ces deux transistors soient identiques, pour préserver la symétrie du montage. On peut envisager de les commander par les tensions de sorties complémentaires d'un comparateur, mais on risque alors de ne pas avoir une parfaite superposition des créneaux de signaux, et de retrouver les difficultés de l'art connu. C'est pourquoi il est préférable de ne commander qu'un seul transistor, 34, par un unique signal d'horloge en créneau qui est tantôt supérieur, tantôt inférieur à la tension continue $V_{réf}$ appliquée sur l'autre transistor 33 : il n'y a plus d'incertitude sur le temps d'ouverture.

Un schéma électrique du suiveur de tension 40 est donné en figure 6. Il est simplement constitué par deux transistors identiques 42 et 43, à effet de champ à enrichissement ($V_T$ 0) montés en série entre deux tensions $+V_{DD}$ et $-V_{SS}$. Le signal d'entrée $V_S$, provenant du point 19 du pont de diodes, est appliqué sur la grille du premier transistor 42. Le signal de sortie, appliqué au point de symétrie 41 du pont de diodes, est prélevé entre source du premier transistor 42 et drain du second transistor 43, dont la grille est reliée à la source. Mais ce montage ne fonctionne pas en suiveur idéal, à cause de la conductance de drain des transistors. Alors qu'un suiveur de tension idéal a une pente égale à 1 -il recopie fidèlement en 41 la tension en 19- celui-ci a une pente de l'ordre de 0,8, ce qui entraine un léger décalage dans le pont, entre les points 19 et 41.

Une pente plus proche de 1 est obtenue avec un montage cascode pour le suiveur de tension selon la figure 7. Il se rapproche du précédent par la nature des transistors à effet de champ, et on y retrouve les deux transistors 42 et 43. Mais leurs conductances de drains sont annulées par deux sources de tensions 44 et 45 : la source de tension 44 est connectée entre la grille du premier transistor 42 et la grille d'un transistor supplémentaire 46, et la source de tension 45 est symétriquement connectée entre la grille du second transistor 43 et la grille d'un autre transistor supplémentaire 47. Les quatre transistors 46, 42, 47 et 43 sont montés en série entre $+V_{DD}$ et $-V_{SS}$. En fait, on peut réaliser ce suiveur de tension soit avec 4 transistors monogrilles, soit avec deux transistors bigrilles : un transistor bigrille pour remplacer les transistors 42 et 46, un bigrille pour remplacer les transistors 43 et 47. La réalisation de sources de tensions 44 et 45 entre grilles est à la portée de l'homme de l'art, et peut se faire de différentes manières.

Les figures 8 et 9 donnent les schémas électriques d'un suiveur de tension 40 réalisé en technologie bipolaire. Le schéma de la figure 8 n'est pas de type cascode ; celui de la figure 9 est cascode. Le fonctionnement de ce suiveur de tension bipolaire sera exposé en s'appuyant sur le montage cascode.

En figure 9, le signal à recopier, prélevé au point 19 du pont de diodes, est appliqué sur la base d'un transistor 48. Celui-ci est alimenté, à partir d'une tension $+V_{CC}$, à travers un transistor 49, et son courant de base est compensé par une source de courant 50. Le transistor 49, monté en suiveur de tension, est commandé sur sa base par une source de courant 51.

Deux diodes 52 et 53 sont montées en série entre la base du transistor 49 et l'émetteur du transistor 48. Le courant qui traverse :
- la première branche formée par les deux transistors 48 et 49,
- la deuxième branche formée par la source de courant 51 et les deux diodes 52 et 53,

est extrait par la source de courant 54 réunie à une source de tension $-V_{CC}$. Si $i_N$ est le courant qui traverse la source 50 (égale au courant de base du transistor 48), $I_N$ est le courant qui traverse le transistor 49, et $I$ est le courant qui travers la source 51, les composants sont calculés pour que

$$i_N + I_N = I$$

et un courant $2I$ est extrait par la source 54.

La diode 52 amène une chute de tension qui équilibre celle causée par la jonction émetteur-base dans le transistor 49. La diode 53 amène une chute de tension qui équilibre celle causée par la jonction émetteur-base dans le transistor 48. Il y a donc équilibre de courants et de tensions dans les deux branches de ce montage : la tension prélevée au point 41, entre les deux diodes 52 et 53, est égale à la tension au point 19, sur la base du transistor 48.

Comme tout dispositif comportant des transistors, les suiveurs de tension présentent un faible courant de fuite : celui-ci n'intervient que sur le temps maximum de blocage utilisable par l'échantillonneur-bloqueur.

Les performances de l'échantillonneur-bloqueur selon l'invention, en technologie MESFET GaAs, avec une capacité de stockage de 500 fF, et des courants de 3mA pour les sources de courant 22 et 24, sont :
- gain en mode suiveur 0,98
- résolution 6 bits, soit environ 1 %
- vitesse d'échantillonnage 500 MHz
- réjection du signal d'entrée <1 % de la gamme dynamique
- incertitude à l'ouverture ≃10ps, compatible avec des signaux à 1 GHz et une résolution de 6 bits.

Ces performances peuvent être doublées en diminuant par un facteur 2 la capacité de stockage, au prix d'une moins bonne réjection du signal d'entrée.

En technologie bipolaire, les performances sont :
- gain en mode suiveur ≃1
- résolution 8 bits, soit 0,25 %
- vitesse d'échantillonnage 100 MHz
- réjection du signal d'entrée 1 ‰
- incertitude à l'ouverture ≃10-20 ps

L'échantillonneur-bloqueur selon l'invention est destiné aux chaines de traitement d'un signal analogique à haute fréquence, en vue de sa transformation en signal numérique. Il est appliqué en particulier en instrumentation, et dans les systèmes de radars et de télécommunication.

## Revendications

1. Echantillonneur-bloqueur à haute fréquence d'échantillonnage, comportant un pont de diodes (13, 14, 15, 16) ayant un point d'entrée (18) sur lequel est appliqué un signal analogique d'entrée ($V_E$), un point de sortie (19) sur lequel est recueilli un signal de sortie ($V_S$) mémorisé dans une capacité de stockage (17), et deux points milieux (20,21) sur lesquels sont forcés les courants de deux sources de courant (22, 24) commandées par deux interrupteurs (33,34)

les deux points milieux (20, 21) étant asservis en tension en mode bloqué d'une valeur constante (K) par rapport à la tension de sortie ($V_S$) : $V_S$-K pour le point milieu "haut" (20) et $V_S$+K pour le point milieu "bas" (21), cet échantillonneur-bloqueur étant caractérisé en ce que

les moyens (36 à 40) d'asservissement de la tension des deux points milieux (20, 21) par rapport à la tension de sortie ($V_S$) sont constitués par:
- une pluralité, en nombre pair, de diodes (36 à 39) montées en diagonale du pont, entre les points milieux "bas" (21) et "haut" (20), et orientées de sorte qu'elles sont polarisées en direct lorsque les diodes (13 à 16) du pont sont polarisées en inverse en mode bloqué
- un suiveur de tension (40) qui prélève la tension de sortie ($V_S$) au point de sortie (19) du pont, et la recopie au point de symétrie (41), qui partage en deux quantités égales ladite pluralité paire de diodes (36 à 39) montées en diagonale du pont.

2. Echantillonneur-bloqueur selon la revendication 1, caractérisé en ce que, si 2n désigne la pluralité paire de diodes (36 à 39) montées en diagonale du pont, et $V_D$ désigne la chute de tension en direct à travers chacune de ces diodes, un premier point milieu (20) du pont est asservi à la tension $V_S$ - $nV_D$, et un deuxième point milieu (21) du pont est asservi à la tension $V_S$ + $nV_D$.

3. Echantillonneur-bloqueur selon la revendication 1, caractérisé en ce qu'il comporte, branchées entre une première source de tension ($+V_{DD}$) et une seconde source de tension (-$V_{SS}$):
- une première source de courant (22) en série avec un premier transistor (33), le point commun entre source de courant (22) et une première électrode d'accès du premier transistor (33) étant connecté au point milieu "haut" (20) du pont de diodes (13 à 16),
- une deuxième source de courant (24) en série avec un second transistor (34), le point commun entre source de courant (24) et une première électrode d'accès du second transistor (34) étant connecté au point milieu "bas" (21) du pont de diodes (13 à 16),
- les deuxièmes électrodes d'accès des deux transistors (33, 34) étant réunies et connectées à une troisième source de courant (35) qui extrait le courant fourni par les deux précédantes sources (22, 24).

4. Echantillonneur-bloqueur selon la revendication 3, caractérisé en ce que les deux transistors (33, 34) sont de caractéristiques identiques et forment une paire différentielle, et en ce qu'une tension continue de référence ($V_{réf}$) est appliquée sur l'électrode de commande du premier transistor (33), tandis qu'une tension d'horloge (H) en créneau est appliquée sur l'électrode de commande du second transistor (34), ce créneau de tension (H) étant alternativement supérieur ou inférieur à la tension de référence ($V_{réf}$).

5. Echantillonneur-bloqueur selon la revendication 4, caractérisé en ce que, en mode suiveur,

- la tension d'horloge (H) sur le second transistor (34) est supérieure à la tension de référence ($V_{réf}$) sur le premier transistor (33)
- le courant fourni par la première source de courant (22) traverse le pont de diodes (13 à 16) et s'ajoute, à travers le second transistor (34) au courant fourni par la deuxième source de courant (24)
- la pluralité paire de diodes (36 à 39) montées en diagonale du pont est polarisée à l'inverse,
- les potentiels entre l'entrée (18) et la sortie (19) du pont étant égaux, la tension d'entrée ($V_E$) est recopiée en sortie ($V_S$).

6. Echantillonneur-bloqueur selon la revendication 4, caractérisé en ce que, en mode bloqué:

- la tension d'horloge (H) sur le second transistor (34) est inférieure à la tension de référence ($V_{réf}$) sur le premier transistor (33)
- le courant fourni par la deuxième source de courant (24) traverse la pluralité paire de diodes (36 à 39) montées en diagonale du pont, et s'ajoute, à travers le premier transistor (33), au courant fourni par la première source de courant (22)
- les diodes (13 à 16) du pont sont polarisées en inverse
- la tension de sortie ($V_S$), mémorisée dans la capacité de stockage (17), est recopiée par le suiveur de tension (40) au point de symétrie (41), au milieu des diodes (36 à 39) montées en diagonale, et asservit la tension aux points milieux (20,21) du pont.

7. Echantillonneur-bloqueur selon la revendication 1, caractérisé en ce que le suiveur de tension (40) est de type cascode, réalisé en transistors à effet de champ, et en ce qu'il comprend quatre transistors (46, 42, 47, 43) montés en série entre deux sources de tensions ($+V_{DD}$, $-V_{SS}$), le signal d'entrée ($V_S$) étant appliqué sur la grille (point 19) du second transistor (42), le signal de sortie étant prélevé sur la source (point 41) de ce même second transistor (42), une première source de tension (44) existant entre la grille du premier transistor (46) et la grille du second transistor (42), et une deuxième source de tension (45) existant entre la grille du troisième transistor (47) et la grille de quatrième transistor (43), qui est de plus réunie à la source dudit transistor (43).

8. Echantillonneur-bloqueur selon la revendication 7, caractérisé en ce que les quatre transistors sont remplacés deux à deux (46 + 42) (47 + 43) par deux transistors bigrilles.

9. Echantillonneur-bloqueur selon la revendication 1, caractérisé en ce que le suiveur de tension (40) est réalisé en transistors bipolaires, et comporte deux branches en parallèle connectées entre deux sources de tension ($+V_{CC}$ et $V_{CC}$):

- la première branche comporte un premier transistor suiveur (48), alimenté par un second transistor (49) monté en suiveur de tension, le courant de base du premier transistor (48) étant compensé par une première source de courant (50),
- la deuxième branche comporte une seconde source de courant (51), qui commande la base du second transistor (49), et deux diodes (52,53) montées en série,
- le courant débité par les deux branches est extrait par une troisième source de courant (54)
- le point d'entrée (19) du suiveur de tension étant la base du transistor suiveur (48), et le point de sortie (41) étant le point commun aux deux diodes (52,53).

10. Echantillonneur-bloqueur selon la revendication 1, caractérisé en ce que sa dynamique est égale à la moitié de autant de fois la chute de tension ($V_D$) d'une diode qu'il y a de diodes (n) (37, 39) entre le point de symétrie (41) de la diagonale du pont et un point milieu du pont (20), plus une diode (13):

$$D = \pm \frac{(n + 1)}{2} \cdot V_D \cdot$$

11. Echantillonneur-bloqueur selon l'une quelconque des revendications précédentes, caractérisé en ce qu'il est réalisé en circuit intégré sur matériau du groupe III-V (GaAs) avec des transistors à effet de champ.

12. Echantillonneur-bloqueur selon l'une quelconque des revendications précédentes, caractérisé en ce qu'il est réalisé en circuit intégré sur silicium, avec des transistors bipolaires.

## Claims

1. A blocking sampler with a high sampling frequency, comprising a diode bridge (13, 14, 15 and 16) having an entry point (18) to which there is applied an input analog signal ($V_E$), an output point (19) at which an output signal ($V_S$) is received stored in the storing capacitor (17), and two intermediate points (20 and 21) to which there are applied the currents of two sources of current (22 and 24) controlled by two switches (33 and 34),

the two intermediate points (20 and 21) being voltage controlled in a blocking mode by a constant value (K) in relation to the output voltage ($V_S$): $V_S$ - Kfor the "high" intermediate point (20) and $V_S$ + Kfor the "low" intermediate point (2), said blocking sampler being characterized in that:

the means (36 through 40) for output voltage ($V_S$) control of the two intermediate points (20 and 21) in relation to the output voltage ($V_S$) are constituted by:

- a even number plurality of diodes (36 through 39) connected diagonally across the bridge between the "low" (21) and "high" (20) intermediate points and orientated in such a manner that they are polarized forwards when the diodes (13 through 16) of the bridge are inversely polarized (blocking mode), and
- a voltage follower (40), which samples the output voltage ($V_S$) at the output point (19) of the bridge and mirrors it at the point of symmetry (41), which divides the said even number plurality of diodes (36 through 39) into two equal quantities, such diodes being arranged diagonally on the bridge.

2. The blocking sampler as claimed in claim 1, characterized in that given 2n denotes the even number plurality of diodes (36 through 39) arranged diagonally across the bridge and given $V_D$ denotes the voltage drop across each of such diodes, a first intermediate point (20) of the bridge is controlled with the voltage $V_S$ - $nV_D$ and a second intermediate point (21) of the bridge is controlled with the voltage $V_S$ + $nV_D$.

3. The blocking sampler as claimed in claim 1, characterized in that it comprises, connected between a first voltage source (+ $V_{DD}$) and a second voltage source (-$V_{SS}$):

- a first current source (22) placed in series with a first transistor (33), the common point between the source of current (22) and a first access electrode of the first transistor (33) being connected with the "high" intermediate (20) point of the bridge of diodes (13 through 16),
- a second source of current (24) placed in series with a second transistor (34), the common point between the source of current (24) and a first access electrode of the second transistor (34) being connected with the "low" intermediate point (21) of the bridge of diodes (13 through 16), and
- the second access electrodes of the transistors (33 and 34) being united and connected with a third source of current (35), which taps the current supplied by the preceding sources (22 and 24).

4. The blocking sampler as claimed in claim 3, characterized in that the two transistors (33 and 34) have identical characteristics and form a differential pair, and in that a direct reference voltage ($V_{ref}$) is applied to the control electrode of the first transistor (33), while a rectangular pulse clock voltage (H) is applied to the control electrode of the second transistor (34), said rectangular pulse voltage (H) being alternatively greater and less than the reference voltage ($V_{ref}$).

5. The blocking sampler as claimed in claim 4, characterized in that in the following mode,
- the clock voltage (H) to the second transistor (34) is greater than the reference voltage ($V_{ref}$) to the first transistor (33),
- the current supplied by the first current source (22) passes through the bridge of diodes (13 through 16) and is added, through the second transistor (34), to the current supplied by the second source (24) of current,
- the even number plurality of diodes (36 through 39) placed diagonally on the bridge is inversely polarized, and
- if potentials between the input (18) and the output (19) of the bridge are equal, the input voltage ($V_E$) is mirrored at the output ($V_S$).

6. The blocking sampler as claimed in claim 4, characterized in that in the blocking mode:
- the clock voltage (H) to the second transistor (34) is less than the reference voltage ($V_{ref}$) to the second transistor (33),
- the current supplied by the second source (24) of current passes through the even number plurality of diodes (36 through 39) placed diagonally in the bridge and is added, on passing through the first transistor (33), to the current supplied by the first source (22) of current,
- the diodes (13 through 16) of the bridge are inversely polarized, and

- the output voltage (V$_S$), stored in the storing capacitor (17), is mirrored by the voltage follower (40) at the point of symmetry (41), intermediately of the diodes (36 through 39) placed diagonally and controlling the voltage at the intermediate points (20 and 21) of the bridge.

7. The blocking sampler as claimed in claim 1, characterized in that the voltage follower (40) is of the series type and made up of field effect transistors, and in that it comprises four transistors (46, 42, 47 and 43) placed in series between two voltage sources (+V$_{DD}$ and -V$_{SS}$), the input signal (V$_S$) being applied to the gate (point 19) of the second transistor (42), the output signal being sampled at the source (point 41) of the same second transistor (42), a first source (44) of voltage existing between the gate of the first transistor (46) and the gate of the second transistor (42), and a second source (45) of voltage existing between the gate of the third transistor (47) and the gate of the fourth transistor (43), which is furthermore connected with the source of the said transistor (43).

8. The blocking sampler as claimed in claim 7, characterized in that the fourth transistors are replaced two by two (46 + 42) (47 + 43) by two twin gate transistors.

9. The blocking sampler as claimed in claim 1, characterized in that the voltage follower (40) is designed using bipolar transistors, and comprises two parallel limbs connected between two voltage sources (+V$_{CC}$ and -V$_{CC}$):
   - the first limb comprises a first transistor (49) placed in circuit as a voltage follower, the base current of the first transistor (48) being compensated by a first source (50) of current,
   - the second limb comprises a second source (51) of current, which controls the base of the second transistor (49), and two diodes (52 and 53) placed in series,
   - the current through the two limbs is tapped by a third source (54) of current, and
   - the input point (19) of the voltage follower being the base of the follower transistor (48), and the output point (41) being the point common to the two diodes (52 and 53).

10. The blocking sampler as claimed in claim 1, characterized in that its dynamic characteristic is equal to as many times the voltage drop

(V$_D$) of a diode as there are diodes (n) (37 and 39) between the point of symmetry (41) of the diagonal of the bridge (20) plus one diode (13):

$$D = \pm \frac{(n + 1)}{2} V_D.$$

11. The blocking sampler as claimed in any one of the preceding claims, characterized in that it is in the form of an integrated circuit on a material of the II-V group (GaAs) with bipolar transistors.

12. The blocking sampler as claimed in any one of the preceding claims, characterized in that it is in the form of an integrated circuit on silicon and with bipolar transistors.

**Ansprüche**

1. Abtast-/Halteschaltung mit Hochfrequenzabtastung, mit einer Diodenbrücke (13, 14, 15, 16), die einen Eingangspunkt (18), an den ein analoges Eingangssignal (V$_E$) angelegt wird, einen Ausgangspunkt (19), an dem ein in einer Speicherkapazität (17) gespeichertes Ausgangssignal (V$_S$) abgenommen wird, und zwei mittlere Punkte (20, 21), an die die Ströme zweier durch zwei Unterbrecher (33, 34) gesteuerter Stromquellen (22, 24) geschickt werden, aufweist,

   wobei die zwei mittleren Punkte (20, 21) im Sperrzustand auf einen konstanten Wert (K) in bezug auf die Ausgangsspannung (V$_S$) spannungsgeregelt werden: V$_S$-Kfür den "oberen" mittleren Punkt (20) und V$_S$+Kfür den "unteren" mittleren Punkt (21), wobei die Abtast-/Halteschaltung dadurch gekennzeichnet ist, daß

   die Mittel (36 bis 49) zur Regelung der Spannung der zwei mittleren Punkte (20, 21) in bezug auf die Ausgangsspannung (V$_S$) durch
   - eine geradzahlige Mehrzahl von Dioden (36 bis 39), die zwischen dem "unteren" (21) und dem "oberen" (20) mittleren Punkt in der Diagonale der Brücke angeordnet und so orientiert sind, daß sie in Durchlaßrichtung betrieben werden, wenn die Dioden (13 bis 16) der Brücke im Sperrzustand in Sperrichtung betrieben werden, und
   - einen Spannungsfolger (40), der die Ausgangsspannung (V$_S$) am Ausgangspunkt (19) der Brücke abgreift und am Symmetriepunkt (41), der die geradzahlige Mehrzahl der in der Diagonale der Brükke angeordneten Dioden (36 bis 39) in zwei gleiche Teile teilt, wiedergibt, gebildet werden.

2. Abtast-/Halteschaltung gemäß Anspruch 1, dadurch gekennzeichnet, daß, wenn 2n die geradzahlige Mehrzahl der in der Diagonalen der Brücke angeordneten Dioden (36 bis 39) bezeichnet und $V_D$ den Spannungsabfall in Durchlaßrichtung an jeder dieser Dioden bezeichnet, ein erster mittlerer Punkt (20) der Brücke auf die Spannung $V_S-nV_D$ eingeregelt und ein zweiter mittlerer Punkt (21) der Brücke auf die Spannung $V_S+nV_D$ eingeregelt wird.

3. Abtast-/Halteschaltung gemäß Anspruch 1, dadurch gekennzeichnet, daß sie zwischen eine erste Spannungsquelle ($+V_{DD}$) und eine zweite Spannungsquelle (-$V_{SS}$) geschaltet ist und umfaßt:
   - eine erste Stromquelle (22), die mit einem ersten Transistor (33) in Reihe geschaltet ist, wobei der gemeinsame Punkt zwischen der Stromquelle (22) und einer ersten Abgriffelektrode des ersten Transistors (33) mit dem "oberen" mittleren Punkt (20) der Diodenbrücke (13 bis 16) verbunden ist,
   - eine zweite Stromquelle (24), die mit einem zweiten Transistor (34) in Reihe geschaltet ist, wobei der gemeinsame Punkt zwischen der Stromquelle (24) und einer ersten Abgriffelektrode des zweiten Transistors (34) mit dem "unteren" mittleren Punkt (21) der Diodenbrücke (13 bis 16) verbunden ist,
   - wobei die zweiten Abgriffelektroden der zwei Transistoren (33, 34) miteinander und mit einer dritten Stromquelle (35) verbunden sind, die den von den zwei oben erwähnten Quellen (22, 24) gelieferten Strom zieht.

4. Abtast-/Halteschaltung gemäß Anspruch 3, dadurch gekennzeichnet, daß die zwei Transistoren (33, 34) identische Kennlinien besitzen und ein Differenzpaar bilden und daß an die Steuerelektrode des ersten Transistors (33) eine Referenzgleichspannung ($V_{ref}$) angelegt wird, während an die Steuerelektrode des zweiten Transistors (34) eine Rechteck- Taktgeberspannung (H) angelegt wird, wobei diese Rechteckspannung H abwechselnd oberhalb und unterhalb der Referenzspannung ($V_{ref}$) liegt.

5. Abtast-/Halteschaltung gemäß Anspruch 4, dadurch gekennzeichnet, daß im Folgermodus
   - die Taktgeberspannung (H) am zweiten Transistor (34) oberhalb der Referenzspannung ($V_{ref}$) am ersten Transistor (33) liegt,
   - der von der ersten Stromquelle (22) gelieferte Strom die Diodenbrücke (13 bis 16) durchläuft und über den zweiten Transistor (34) dem von der zweiten Stromquelle (24) gelieferten Strom hinzugefügt wird,
   - die geradzahlige Mehrzahl der Dioden (36 bis 39), die in der Diagonalen der Brücke angeordnet sind, gesperrt sind,
   - die Potentiale zwischen dem Eingang (18) und dem Ausgang (19) der Brücke gleich sind und die Eingangsspannung ($V_E$) am Ausgang ($V_S$) wiedergegeben wird.

6. Abtast-/Halteschaltung gemäß Anspruch 4, dadurch gekennzeichnet, daß im Sperrzustand
   - die Taktgeberspannung (H) am zweiten Transistor (34) unterhalb der Referenzspannung ($V_{ref}$) am ersten Transistor (33) liegt,
   - der von der zweiten Stromquelle (24) gelieferte Strom die geradzahlige Mehrzahl der in der Diagonalen der Brücke angeordneten Dioden (36 bis 39) durchläuft und über den ersten Transistor (33) dem von der ersten Stromquelle (22) gelieferten Strom hinzugefügt wird,
   - die Dioden (13 bis 16) der Brücke gesperrt sind,
   - die Ausgangsspannung ($V_S$), die in der Speicherkapazität (17) gespeichert ist, durch den Spannungsfolger (40) am Symmetriepunkt (41) in der Mitte zwischen den diagonal angeordneten Dioden (46 bis 39) wiedergegeben wird und die Spannung an den mittleren Punkten (20, 21) der Brücke regelt.

7. Abtast-/Halteschaltung gemäß Anspruch 1, dadurch gekennzeichnet, daß der Spannungsfolger (40) vom Kaskodentyp ist, der aus Feldeffekttransistoren gebildet ist, und daß sie vier Transistoren (46, 42, 47, 43) umfaßt, die zwischen den Spannungsquellen ($+V_{DD}$, $+V_{SS}$) in Reihe geschaltet sind, wobei das Eingangssignal ($V_S$) an das Gate (Punkt 19) des zweiten Transistors (42) angelegt wird, wobei das Ausgangssignal an der Source (Punkt 41) desselben zweiten Transistors (42) abgegriffen wird, wobei zwischen dem Gate des ersten Transistors (46) und dem Gate des zweiten Transistors (42) eine erste Spannungsquelle (44) und zwischen dem Gate des dritten Transistors (47) und dem Gate des vierten Transistors (43) eine zweite Spannungsquelle (45), die außerdem mit der Source des Transistors (43) verbunden ist, vorhanden sind.

8. Abtast-/Halteschaltung gemäß Anspruch 7, dadurch gekennzeichnet, daß die vier Transistoren jeweils paarweise (46 + 42) (47 + 43) durch zwei Doppelgate-Transistoren ersetzt werden.

9. Abtast-/Halteschaltung gemäß Anspruch 1, dadurch gekennzeichnet, daß die Spannungsfolgerschaltung (40) aus bipolaren Transistoren hergestellt ist und zwei parallele Zweige aufweist, die zwischen die zwei Spannungsquellen ($+V_{CC}$ und $-V_{CC}$) geschaltet sind:
   - der erste Zweig enthält einen ersten Folgertransistor (48), der von einem als Spannungsfolger angeordneten zweiten Transistor (49) versorgt wird, wobei der Basisstrom des ersten Transistors (48) durch eine erste Stromquelle (50) kompensiert wird,
   - der zweite Zweig enthält eine die Basis des zweiten Transistors (49) steuernde zweite Stromquelle (51) und zwei in Reihe angeordnete Dioden (52, 53),
   - der von den zwei Zweigen abgegebene Strom wird von einer dritten Stromquelle (54) gezogen,
   - wobei der Eingangspunkt (19) des Spannungsfolgers die Basis des Transistorfolgers (48) ist und der Ausgangspunkt (41) der gemeinsame Punkt der zwei Dioden (52, 53) ist.

10. Abtaste-/Halteschaltung gemäß Anspruch 1, dadurch gekennzeichnet, daß ihre Dynamik gleich der Hälfte des Spannungsabfalls ($V_D$) einer Diode, multipliziert mit der Anzahl der Dioden (n) (38, 39), die zwischen dem Symmetriepunkt (41) der Diagonalen der Brücke und einem mittleren Punkt der Brücke (20) vorhanden sind, plus einer weiteren Diode (13), ist: $D = \pm(n + 1) \cdot V_D/2$.

11. Abtast-/Halteschaltung gemäß einem der vorangehenden Ansprüche, dadurch gekennzeichnet, daß sie als integrierte Schaltung auf einem Material der Gruppe III-V (GaAs) mit Feldeffekttransistoren verwirklicht ist.

12. Abtast-/Halteschaltung gemäß einem der vorangehenden Ansprüche, dadurch gekennzeichnet, daß sie als integrierte Schaltung auf Silizium mit Bipolartransistoren verwirklicht ist.

# FIG_1

# FIG_2

# FIG_3

# FIG_4

FIG_5

FIG_6

FIG_7

FIG_8

FIG_9